# EUROPEAN PATENT SPECIFICATION

(11) **EP 4 636 408 B1**
(45) Date of publication and mention of the grant of the patent: **23.09.2026**
(21) Application number: 25169115.0
(22) Date of filing: 08.04.2025
(51) Int. Cl.: G01R 19/25, G01R 15/18

(54) **CURRENT SENSOR DEVICE**
STROMSENSORVORRICHTUNG
DISPOSITIF DE CAPTEUR DE COURANT

(30) Priority: 18.04.2024 JP 2024067404
(43) Date of publication of application: 22.10.2025
(73) Proprietor: Tokin Corporation, Shiroishi-shi, Miyagi 989-0223 (JP)
(72) Inventor: MORI, Masashi, Shiroishi-shi, Miyagi, 989-0223 (JP); CHIBA, Mitsuharu, Shiroishi-shi, Miyagi, 989-0223 (JP); URATA, Junetsu, Shiroishi-shi, Miyagi, 989-0223 (JP); SAITO, Masuto, Shiroishi-shi, Miyagi, 989-0223 (JP); YOSHINARI, Tetsuya, Shiroishi-shi, Miyagi, 989-0223 (JP); CHANG, Kang-Shuo, 221432 New Taipei City (TW); LI, Chao Tsung, 221432 New Taipei City (TW)
(74) Representative: Prüfer & Partner mbB Patentanwälte · Rechtsanwälte

(56) References cited:
- EP-B1- 4 075 150
- JP-A- 2023 146 957
- US-A1- 2014 320 112

## Description

### BACKGROUND OF THE INVENTION

This invention relates to a current sensor device.

JPA 2023-146957 (Patent Document 1) discloses an example of a current sensor device of a self-oscillating type.

The current sensor device disclosed in Patent Document 1 has a magnetic core with a ring shape. A secondary conductor is wound on the magnetic core, and a primary conductor extends through a central hole of the magnetic core.

In the current sensor device of Patent Document 1, a current is applied through the secondary conductor during detection. The direction of the current flowing through the secondary conductor is switched based on a pulse signal. When a current does not flow through the primary conductor, the pulse signal has a duty ratio of 0.5.

In the current sensor device of Patent Document 1, variation of the current flowing through the primary conductor influences the current flowing through the secondary conductor. The current flowing through the secondary conductor is converted into a voltage which is used not only to detect the current flowing through the primary conductor but also to generate the pulse signal to switch the direction of the current flowing through the secondary conductor.

In the current sensor device of Patent Document 1, the magnetic core may become magnetically saturated when the current flowing through the primary conductor includes a large amplitude alternating current component. As a result, the current sensor device of Patent Document 1 may detect the large-amplitude alternating current component as a direct current.

### SUMMARY OF THE INVENTION

It is an object of the present invention to provide a current sensor device which does not erroneously detect a large-amplitude alternating current component as a direct current.

One aspect of the present invention provides a current sensor device which is of a self-oscillating type and detects a current flowing through a primary conductor. The current sensor device comprises a self-oscillating circuit, a duty ratio calculation portion, a clock introducing portion, a resampling portion and a low-pass filter. The self-oscillating circuit has a magnetic core with a ring shape. The primary conductor extends through a central hole of the magnetic core. The self-oscillating circuit generates a pulse signal in response to the current flowing through the primary conductor and operates based on the pulse signal. The duty ratio calculation portion calculates a duty ratio of the pulse signal and outputs a duty ratio signal representing the duty ratio. The clock introducing portion generates a clock signal having a constant frequency. The resampling portion receives the duty ratio signal and the clock signal and resamples the duty ratio signal based on the clock signal to generate a resampling signal. The low-pass filter integrates the resampling signal.

According to the one aspect of the present invention, the current sensor device resamples the duty ratio signal, which represents the duty ratio of the pulse signal generated by the self-oscillating circuit, based on the clock signal having the constant frequency. The resampling signal generated by the resampling is not influenced by an oscillation frequency of the self-oscillating circuit or a period of the pulse signal. Accordingly, even if a large amplitude alternating current component is included in the current flowing through the primary conductor, no part of the alternating current component is erroneously detected as a direct current component.

An appreciation of the objectives of the present invention and a more complete understanding of its structure may be had by studying the following description of the preferred embodiment and by referring to the accompanying drawings.

### BRIEF DESCRIPTION OF THE DRAWINGS

Fig. 1 is a block diagram showing a current sensor device according to one embodiment of the present invention.
Fig. 2 is a diagram describing a relationship between a magnetic core included in the current sensor device and each of a primary conductor and a secondary conductor which are also included in the current sensor device.
Fig. 3 is a graph showing a waveform of an alternating current flowing through a primary conductor of a current sensor device having a structure in which a resampling portion is removed from the current sensor device of Fig. 1 and a waveform of a detection signal of the current sensor device.
Fig. 4 is a graph showing a waveform of an alternating current flowing through a primary conductor of the current sensor device of Fig. 1 and a waveform of a detection signal of the current sensor device.

While the invention is susceptible to various modifications and alternative forms, specific embodiments thereof are shown by way of example in the drawings and will herein be described in detail. It should be understood, however, that the drawings and detailed description thereto are not intended to limit the invention to the particular form disclosed, but on the contrary, the intention is to cover all modifications, and alternatives falling within the scope of the present invention as defined by the appended claims.

### DETAILED DESCRIPTION

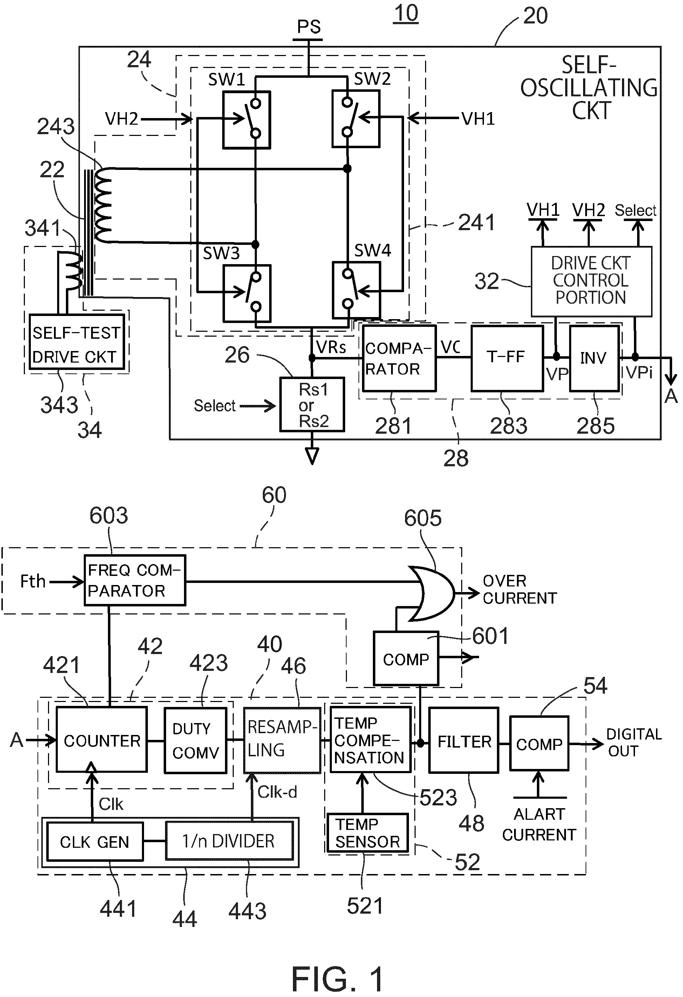

Referring to Fig. 1, a current sensor device 10 according to an embodiment of the present invention is provided with a self-oscillating circuit 20, a detection portion 40 and an overcurrent detecting portion 60. The current sensor device 10 of the present embodiment is a current sensor device of a self-oscillating type and detects a current, i.e., a primary current, flowing through a primary conductor 70 described later.

As shown in Fig. 1, the current sensor device 10 of the present embodiment is further provided with a self-diagnostic portion 34. The self-diagnostic portion 34 has an additional conductor 341 and a self-test drive circuit, or a current supply portion, 343. The additional conductor 341 extends through a central hole of a magnetic core 22 at least in part. The additional conductor 341 may be wound on the magnetic core 22. The self-test drive circuit 343 supplies a current to the additional conductor 341 when the current sensor device 10 is tested. The detailed description of the self-diagnostic portion 34 will be omitted here.

As shown in Fig. 1, the self-oscillating circuit 20 is provided with the magnetic core 22, a drive circuit 24, a detection resistor 26, a pulse signal generating circuit 28 and a drive circuit control portion 32.

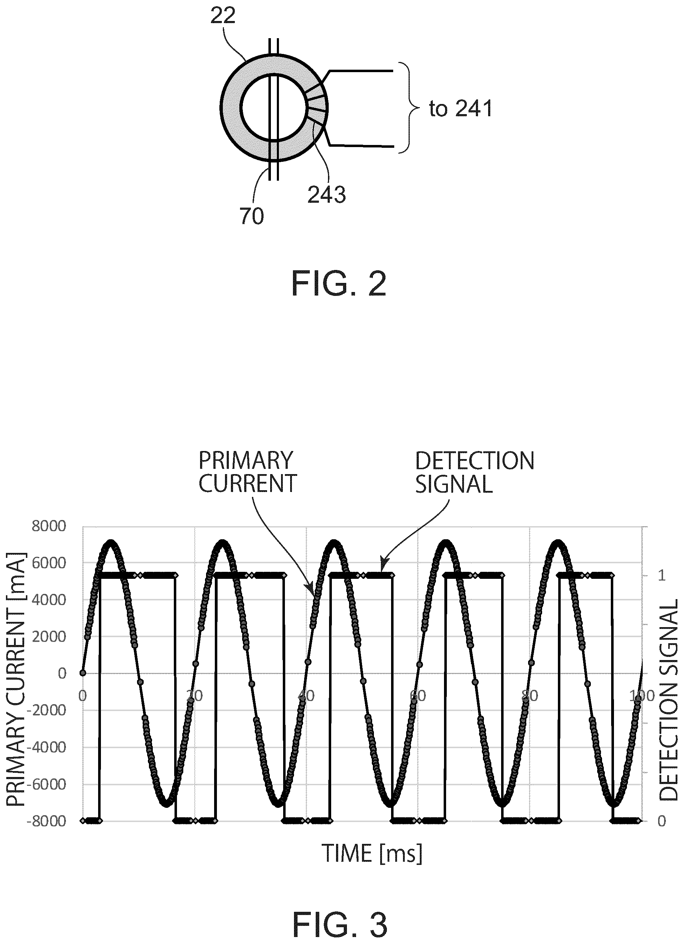

As shown in Fig. 2, the magnetic core 22 has a ring shape with a central hole. The magnetic core 22 is associated with the primary conductor 70 and a secondary conductor, or a load, 243. In detail, the primary conductor 70 extends through the central hole of the magnetic core 22 while the secondary conductor 243 is wound on the magnetic core 22.

As shown in Fig. 1, the drive circuit 24 has a drive portion 241 and a load 243. In the present embodiment, the drive portion 241 is an H-bridge circuit having four switches SW1, SW2, SW3 and SW4. Moreover, in the present embodiment, the load 243 is the secondary conductor 243 mentioned above. The drive portion 241 is connected to a power source and is a circuit which switches a flowing direction of a current, or a secondary current, flowing through the load 243.

As shown in Fig. 1, the detection resistor 26 is connected to the drive circuit 24 in series. The detection resistor 26 converts the current flowing through the secondary conductor 243, which is the load, into a voltage and produces a detected voltage VRs at one of ends thereof. As described later, in the present embodiment, the detection resistor 26 is formed so that it can select one of a first resistance value Rs1 and a second resistance value Rs2 larger than the first resistance value Rs1. The detection resistor 26 serves as a resistor having either the first resistance value Rs1 or the second resistance value Rs2 in response to a switching signal (Select) applied from the outside.

As shown in Fig. 1, the pulse signal generating circuit 28 is provided with a comparator 281, a T-flip-flop 283 and an inverter 285. The comparator 281 compares the detected voltage VRs with a threshold voltage Vth and outputs an output voltage VC which is of an ON state when the detected voltage VRs is over the threshold voltage Vth and which is of an OFF state when the detected voltage VRs is below the threshold voltage Vth. The T-flip-flop 283 detects a rising edge of the output voltage VC and inverts an on/off state of a pulse signal VP, which is an output signal of the T-flip-flop 283, each time the rising edge is detected. The inverter 285 outputs an inverted pulse signal VPi made by inverting the on/off state of the pulse signal VP. Thus, the pulse signal generating circuit 28 monitors the detected voltage VRs generated at the one end of the detection resistor 26 and generates the pulse signal VP by inverting the on/off state of the pulse signal VP in response to the detected voltage VRs. Hereinafter, in the present description, both the pulse signal VP and the inverted pulse signal VPi may be simply referred to as pulse signals.

As understood from Fig. 1, the drive circuit control portion 32 is supplied with the pulse signals, i.e., the pulse signal VP and the inverted pulse signal VPi, from the pulse signal generating circuit 28. The drive circuit control portion 32 generates drive signals VH, i.e., a first drive signal VH1 and a second drive signal VH2, based on the pulse signals from the pulse signal generating circuit 28. In addition, the drive circuit control portion 32 generates a switching signal Select.

As shown in Fig. 1, the drive signals VH, i.e., the first drive signal VH1 and the second drive signal VH2, from the drive circuit control portion 32 are supplied to the drive portion 241. The first drive signal VH1 and the second drive signal VH2 are used to control on-off states of the switches SW1-SW4. The drive portion 241 switches a flowing direction of the current flowing through the secondary conductor 243 in response to the first drive signal VH1 and the second drive signal VH2. Both the first drive signal VH1 and the second drive signal VH2 are based on the pulse signal VP. Accordingly, it can be said that the drive portion 241 switches the flowing direction of the current flowing through the secondary conductor 243 based on the pulse signal VP.

Here, it is assumed that the current sensor device 10 is ideal and that no current flows through the primary conductor 70. In that case, the self-oscillating circuit 20 operates so that a duty ratio of the pulse signal VP is equal to 50%. In other words, in the current sensor device 10 which is ideal, the self-oscillating circuit 20 operates so that an on-period and an off-period of the pulse signal are equal when no current flows through the primary conductor 70.

Next, it is assumed that a current flows through the primary conductor 70 in the current sensor device 10. In that case, a current flowing through the secondary conductor 243 is varied by variation of the current flowing through the primary conductor 70. The variation of the current flowing through the secondary conductor 243 varies the detected voltage VRs. As a result, the pulse signals, i.e., the pulse signal VP and the inverted pulse signal VRi, generated by the pulse signal generating circuit 28 are also varied.

In the current sensor device 10 of Fig. 1, the drive circuit control portion 32 outputs the pulse signal VP as the first drive signal VH1 and outputs the inverted pulse signal VRi as the second drive signal VH2 during normal operation. The drive circuit control portion 32 also outputs the switching signal to select the second resistance value Rs2 larger than the first resistance value Rs1 during normal operation. The first drive signal VH1 and the second drive signal VH2 output from the drive circuit control portion 32 are used to control the switches SW1-SW4 in the drive portion 241.

As described above, the self-oscillating circuit 20 generates the pulse signals, i.e., the pulse signal VP and the inverted pulse signal VRi, in response to the current flowing through the primary conductor 70 and operates based on the pulse signals.

As shown in Fig. 1, the detection portion 40 is provided with a duty ratio calculation portion 42, a clock introducing portion 44, a resampling portion 46 and a low-pass filter 48. In the present embodiment, the detection portion 40 is further provided with a temperature compensation portion 52 and a comparator 54, which are not essential.

As shown in Fig. 1, the duty ratio calculation portion 42 has a counter 421 and a duty converting portion 423. The clock introducing portion 44 has a base clock generating portion 441 and a one-nth frequency divider 443. The base clock generating portion 441 generates a base clock signal Clk with a predetermined frequency. The base clock signal Clk is supplied to the one-nth frequency divider 443 and to the counter 421 of the duty ratio calculation portion 42. The one-nth frequency divider 443 divides the base clock signal Clk into one-nth and generates a clock signal Clk-d with a constant frequency, or one-nth of the predetermined frequency. Thus, in the present embodiment, the clock introducing portion 44 generates the base clock signal Clk and the clock signal Clk-d.

As understood from Fig. 1, to the counter 421 of the duty ratio calculation portion 42, the inverted pulse signal VPi, or the pulse signal, from the inverter 285 and the base clock signal Clk from the base clock generating portion 441 are inputted. The counter 421 counts an on-period and an off-period at each period of the inverted pulse signal VPi based on the base clock signal Clk. The duty converting portion 423 calculates a duty ratio from counted results of the counter 421 at each period of the inverted pulse signal VPi and generates a duty ratio signal representing the duty ratio calculated. In this way, the duty ratio calculation portion 42 calculates the duty ratio of the pulse signal, or the inverted pulse signal VPi, and outputs the duty ratio signal representing the duty ratio.

As shown in Fig. 1, the resampling portion 46 receives the duty ratio signal from the duty ratio calculation portion 42 and the clock signal Clk-d from the one-nth frequency divider 443. The resampling portion 46 resamples the duty ratio signal based on the clock signal Clk-d to generate a resampling signal. This resampling signal is not influenced by an oscillation frequency of the self-oscillating circuit 20, or the period of the pulse signal. Incidentally, the resampling portion 46 may be formed using a D-flipflop (D-FF) with a plurality of bits, for example. In that case, the D-FF has the number of bits equal to the number of bits of the duty ratio signal.

As shown in Fig. 1, the temperature compensation portion 52 is provided with a temperature sensor 521 and a temperature compensation circuit 523. The temperature sensor 521 detects a surrounding temperature and generates a temperature detection signal representing the surrounding temperature detected. The temperature compensation circuit 523 performs temperature compensation to the resampling signal from the resampling portion 46 based on the temperature detection signal and generates a temperature-compensated resampling signal.

As shown in Fig. 1, the low-pass filter 48 integrates the temperature-compensated resampling signal to remove a high-frequency component therefrom. The resampling signal from which the high-frequency component is removed is outputted to the comparator 54.

The comparator 54 receives the output of the low-pass filter 48 and compares the output of the low-pass filter 48 with a predetermined threshold value. The comparator 54 outputs a detection signal (Digital out) based on a comparison result between the output of the low-pass filter 48 and the predetermined threshold value. As the predetermined threshold value, each of a threshold value for a direct current and a threshold value for an alternating current may be prepared. In a case where the comparator 54 supports both the threshold value for the direct current and the threshold value for the alternating current, the comparator 54 outputs, as the detection signals, a detected signal for the direct current and a detected signal for the alternating current to corresponding output terminals (not shown), respectively.

As shown in Fig. 1, the overcurrent detecting portion 60 is provided with an overcurrent comparator 601, a frequency comparator 603 and an OR circuit, or a logical addition circuit, 605.

The overcurrent comparator 601 compares a current value represented by the duty ration signal from the temperature compensation circuit 523 with an overcurrent threshold value predetermined. The overcurrent comparator 601 outputs an overcurrent detection signal when the current value represented by the duty ratio signal exceeds the overcurrent threshold value.

To the frequency comparator 603, a frequency threshold Fth predetermined is inputted. The frequency comparator 603 finds a frequency of the pulse signal, or the inverted pulse signal VRi, from a counted value of the counter 421 and compares the frequency found with the frequency threshold Fth. When the frequency of the pulse signal exceeds the frequency threshold value Fth, the frequency comparator 603 outputs an overcurrent detection signal.

The overcurrent detection signal from the overcurrent comparator 601 and the overcurrent detection signal from the frequency comparator 603 are inputted to the OR circuit 605. The OR circuit 605 outputs any one of the overcurrent detection signals to the outside thereof as an overcurrent flag showing an overcurrent.

As mentioned above, the current sensor device 10 according to the present embodiment uses the magnetic core 22 and is capable of detecting the current flowing through the primary conductor 70 based on the variation of the duty ratio of the pulse signal. Also, the current sensor device 10 is provided with the overcurrent detecting portion 60, so that it can detect a case where the current flowing through the primary conductor 70 is too large to be correctly detected by the detection portion 40.

Next, consideration will be made about a case where the current flowing through the primary conductor 70 includes an alternating component with large amplitude. When the current including the alternating component with the large amplitude flows through the primary conductor 70, the magnetic core 22 may become a condition of magnetic saturation. When the magnetic core 22 is magnetically saturated, the oscillation frequency of the self-oscillating circuit 20 abruptly increases. On the other hand, the duty ratio calculation portion 42 calculates the duty ratio at each period of the pulse signal regardless of the oscillation frequency of the self-oscillating circuit 20. This means that a calculating frequency for calculating the duty ratio increases when the oscillation frequency of the self-oscillating circuit 20 increases. In other words, a sampling frequency for the duty ratio increases. If the duty ratio signal based on such a high sampling frequency is supplied to the low-pass filter 48, the low-pass filter 48 would operate as a filter with a wide band wider than an assumed pass band. As a result, the current sensor device 10 would erroneously detect a part of the alternating component as a direct current, as shown in Fig. 3.

Fig. 3 shows a waveform of an alternating current which includes no direct current component or a direct current component of zero and which flows through the primary conductor 70 and a detection signal from the comparator 54 in a case where the current sensor device 10 does not have the resampling portion 46. On the waveform of the alternating current (5 Arms) flowing through the primary conductor 70, timings at which the duty ratio signal is outputted from the duty ratio calculation portion 42 are depicted by dots. As understood from Fig. 3, when the frequency at which the duty ratio signal is outputted is high, the detection signal is varied in response to variation of the alternating current. In other words, though the alternating current includes no direct current component or the direct current component of zero, a part of the alternating current is erroneously detected as a direct current (a detection signal "1").

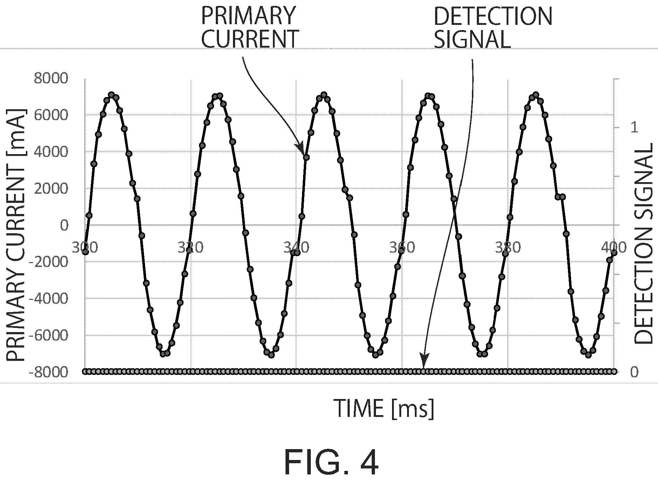

In contrast, in the current sensor device 10 according to the present embodiment, the duty ratio signal from the duty ratio calculation portion 42 is supplied to the low-pass filter 48 after it is resampled in the resampling portion 46. The resampling portion 46 performs resampling using the clock signal Clk-d as described above. The clock signal Clk-d is obtained by frequency-dividing the base clock signal Clk generated by the base clock generating portion 441 and independent of the oscillation frequency of the self-oscillating circuit 20. Accordingly, the resampling signal is not influenced by the oscillation frequency of the self-oscillating circuit 20. In other words, the low-pass filter 48 always operates as a low-pass filter with a fixed band, or a designed pass band. Thus, even if a current flowing through the primary conductor 70 includes an alternating component with a large amplitude, the current sensor device 10 does not erroneously detect a part of the alternating current as a direct current, as shown in Fig. 4.

Fig. 4 shows a waveform of an alternating current (5 Arms) which includes no direct current component or a direct current component of zero and which flows through the primary conductor 70 in the current sensor device 10 according to the present embodiment and the detection signal from the comparator 54. On the waveform of the alternating current flowing through the primary conductor 70, timings at which the duty ratio signal is outputted from the duty ratio calculation portion 42 are depicted by dots. As apparent from comparing with Fig. 3, a frequency at which the duty ratio signal is outputted, or a resampling frequency, is significantly lower than that of the case of Fig. 3. As a result, the current sensor device 10 according to the present embodiment is not influenced by existence of the alternating current, so that the detection signal indicates "0". Accordingly, it can be said that, even if a current flowing through the primary conductor 70 includes an alternating current with a large amplitude, the current sensor device 10 according to the present embodiment does not erroneously detect a part of the alternating current.

As described above, when the current flowing through the primary conductor 70 includes the alternating current with the large amplitude, the current sensor device of the self-oscillating type outputs different detection signals according to whether the duty ratio signal is resampled or not. Accordingly, if a current flowing through the primary conductor 70 includes an alternating current with a large amplitude and a part of the alternating current is erroneously detected as a direct current, it can be assumed that resampling is not performed. On the other hand, if a current flowing through the primary conductor 70 includes an alternating current with a large amplitude and a part of the alternating current is not detected as a direct current, it can be assumed that resampling is performed at a constant frequency.

Incidentally, the magnetic core 22 of the current sensor device 10 according to the present embodiment is magnetized while the current sensor device 10 is used. Accordingly, output characteristics of the current sensor device 10 are varied in accordance with a magnetization state of the magnetic core 22. So, the current sensor device 10 according to the present embodiment demagnetizes the magnetic core 22 whenever it is activated or power is turned on to suppress the variation of the output characteristics. This control is performed by the drive circuit control portion 32.

As understood from Fig. 1, the drive circuit control portion 32 outputs the switching signal to select the resistance value in the detection resistor 26. The detection resistor 26 has the first resistance value Rs1 and the second resistance value Rs2 larger than the first resistance value Rs1. The detection resistor 26 switches between the first resistance value Rs1 and the second resistance value Rs2 as the resistance value thereof in accordance with the switching signal from the drive circuit control portion 32.

The drive circuit control portion 32 generates the switching signal to select the first resistance value Rs1 during a predetermined period from when the power is turned on. After the predetermined period, the drive circuit control portion 32 generates the switching signal to select the second resistance value Rs2, as described before. In this way, the drive circuit control portion 32 controls a current flowing through the drive circuit 24.

In addition, the drive circuit control portion 32 outputs demagnetization pulse signals as the drive signals VH, i.e., the first drive signal VH1 and the second drive signal VH2, during the predetermined period from when the power is turned on. Each of the demagnetization pulse signals is a signal obtained by frequency modulating a pulse signal with a predetermined duty ratio. In detail, the drive circuit control portion 32 frequency modulates a pulse signal with a duty ratio of 51.5 ± 1% and outputs the frequency-modulated pulse signals as the demagnetization pulse signals. This frequency modulation is performed so that its frequency increases as time proceeds. The self-oscillating circuit 20 operates based on the demagnetization pulse signals during the predetermined period from when the power is turned on. As just described, during the predetermined period, the drive portion 241 of the drive circuit 24 switches the direction of the current flowing through the secondary conductor 243 based on the demagnetization pulse signals in place of the pulse signals. As a result, the magnetic core 22 is demagnetized whenever the current sensor device 10 is activated, so that the variation of the output characteristics of the current sensor device 10 are suppressed within a permissible range.

In the present embodiment, the reason for using the frequency-modulated pulse signals as the demagnetization pulse signals is based on experimental results made by the present inventors. The present inventors performed demagnetization experiments for the magnetic core 22 using frequency-modulated pulse signals and demagnetization experiments for the magnetic core 22 using amplitude-modulated pulse signals. And, from these experimental results, the present inventors found that use of the frequency-modulated pulse signals can more effectively demagnetize the magnetic core 22 than use of the amplitude-modulated pulse signals. Moreover, from results of demagnetization experiments in which the duty ratio of the amplitude-modulated pulse signal was changed to various values, it was found that the maximum demagnetization effect was obtained when the duty ratio was 51.5%. Furthermore, it was confirmed that a demagnetization effect of approximately twice or more is obtained at a duty ratio of 51.5 ± 1% compared with when the duty ratio is 50%. The frequency modulation is not particularly limited, but may be performed, for example, with increasing the frequency by 11% per step from 70 Hz to 25 kHz. In addition, time required for demagnetization is not particularly limited, but it may be approximately 150 ms under the frequency conditions mentioned above.

Although the specific explanation about the present invention is made above with reference to concrete embodiments, the present invention is not limited thereto but susceptible of various modifications and alternative forms without departing from the scope of the invention as defined by the appended claims.

Though the clock signal Clk-d is generated using the base clock generating portion 441 and the one-nth frequency divider 443 in the aforementioned embodiment, the generation method of the clock signal Clk-d is not particularly limited provided that the clock signal Clk-d has a constant frequency regardless of an amplitude of a current flowing through the primary conductor 70. For example, the clock signal Clk-d may be generated using an oscillation circuit, or a clock generating portion, other than the base clock generating portion 441. In addition, the frequency of the clock signal Clk-d should be decided in consideration of specifications of the low-pass filter 48 and the oscillation frequency of the self-oscillating circuit 20 which operates properly, and it is not necessarily lower than a frequency of the self-oscillating circuit 20.

In the present invention, the self-oscillating circuit 20 may be provided with a chopper circuit between the drive portion 241 and the secondary conductor 243 in a manner similar to the current sensor device disclosed in Patent Document 1.

While there has been described what is believed to be the preferred embodiment of the invention, those skilled in the art will recognize that other and further modifications may be made thereto without departing from the scope of the invention, and it is intended to claim all such embodiments that fall within the scope of the invention as defined by the appended claims.

## Claims

1. A current sensor device (10) which is of a self-oscillating type and detects a current flowing through a primary conductor (70), wherein:
the current sensor device comprises a self-oscillating circuit (20), a duty ratio calculation portion (42), a clock introducing portion (44), a resampling portion (46) and a low-pass filter (48);
the self-oscillating circuit has a magnetic core (22) with a ring shape
the primary conductor extends through a central hole of the magnetic core;
the self-oscillating circuit is configured to generate a pulse signal in response to the current flowing through the primary conductor and to operate based on the pulse signal;
the duty ratio calculation portion is configured to calculate a duty ratio of the pulse signal and to output a duty ratio signal representing the duty ratio;
the clock introducing portion is configured to generate a clock signal having a constant frequency;
**characterised in that**
the resampling portion is configured to receive the duty ratio signal and the clock signal and to resample the duty ratio signal based on the clock signal to generate a resampling signal; and
the low-pass filter is configured to integrate the resampling signal.

2. The current sensor device as recited in claim 1, wherein:
the duty ratio calculation portion has a counter (421) and a duty converting portion (423);
the clock introducing portion has a base clock generating portion (441) and a frequency divider (443);
the base clock generating portion is configured to generate a base clock signal;
the counter is configured to count an on-period and an off-period in each period of the pulse signal based on the base clock signal;
the duty converting portion is configured to calculate a duty ratio from counted results of the counter for each period of the pulse signal and to generate a duty ratio signal representing the duty ratio; and
the frequency divider is configured to perform frequency division for the base clock signal from the base clock generating portion and to output a divided signal as the clock signal.

3. The current sensor device as recited in claim 1 or 2, wherein the current sensor device further has a comparator (54) which is configured to receive an output of the low-pass filter and to compare the output of the low-pass filter and a predetermined threshold value.

4. The current sensor device as recited in any one of claims 1 to 3, wherein:
the self-oscillating circuit comprises a drive circuit (24), a detection resistor (26) and a pulse signal generating circuit (28);
the drive circuit has a drive portion (241) and a load (243);
the load comprises a secondary conductor wound on the magnetic core;
the detection resistor is connected to the drive circuit in series and is configured to convert a current flowing through the secondary conductor into a voltage to generate a detected voltage at one of ends thereof;
the pulse signal generating circuit is configured to generate the pulse signal in response to the detected voltage;
the drive portion is configured to change a flowing direction of the current flowing through the secondary conductor based on the pulse signal; and
the pulse signal generating circuit is configured to monitor the detected voltage generated at the one of the ends of the detection resistor and to switch an on/off state of the pulse signal.

5. The current sensor device as recited in claim 4, wherein the drive portion comprises an H-bridge circuit having four switches (SW1, SW2, SW3, SW4).

6. The current sensor device as recited in any one of claims 1 to 3, wherein:
the self-oscillating circuit has a drive circuit control portion (32);
the drive circuit control portion is configured to perform frequency modulation of the pulse signal during a predetermined period from turning on a power to generate a demagnetization pulse signal which is used to perform AC demagnetization for the magnetic core and has a duty ratio of 51.5 ± 1 %; and
the self-oscillating circuit is configured to operate based on the demagnetization pulse signal for the predetermined period.

7. The current sensor device as recited in claim 6, wherein:
the self-oscillating circuit comprises a drive circuit and a detection resistor;
the detection resistor is connected to the drive circuit in series;
the detection resistor is configured to be switched between a first resistance value and a second resistance value larger than the first resistance value in response to a switching signal; and
the drive circuit control portion is configured to generate the switching signal for selecting the first resistance value during the predetermined period and for selecting the second resistance value after the predetermined period to control a current flowing through the drive circuit.

8. The current sensor device as recited in claim 6, wherein:
the self-oscillating circuit comprises a drive circuit;
the drive circuit comprises a drive portion and a load;
the load comprises a secondary conductor wound on the magnetic core; and
the drive portion of the drive circuit is configured to switch a flowing direction of a current flowing thorough the secondary conductor based on the demagnetization pulse signal in place of the pulse signal during the predetermined period.

## Patentansprüche

1. Stromsensorvorrichtung (10), die von einem selbstschwingenden Typ ist und einen Strom erfasst, der durch einen Primärleiter (70) fließt, wobei:
die Stromsensorvorrichtung eine selbstschwingende Schaltung (20), einen Tastverhältnisberechnungsabschnitt (42), einen Takteinführungsabschnitt (44), einen Neuabtastabschnitt (46) und einen Tiefpassfilter (48) umfasst;
die selbstschwingende Schaltung einen Magnetkern (22) mit einer Ringform aufweist;
der Primärleiter sich durch ein zentrales Loch des Magnetkerns erstreckt;
die selbstschwingende Schaltung konfiguriert ist, um ein Pulssignal als Reaktion auf den Strom zu erzeugen, der durch den Primärleiter fließt, und um basierend auf dem Pulssignal zu arbeiten;
der Tastverhältnisberechnungsabschnitt konfiguriert ist, um ein Tastverhältnis des Pulssignals zu berechnen und um ein Tastverhältnissignal auszugeben, das das Tastverhältnis darstellt;
der Takteinführungsabschnitt konfiguriert ist, um ein Taktsignal mit einer konstanten Frequenz zu erzeugen;
**dadurch gekennzeichnet, dass**
der Neuabtastabschnitt konfiguriert ist, um das Tastverhältnissignal und das Taktsignal zu empfangen und das Tastverhältnissignal basierend auf dem Taktsignal neu abzutasten, um ein Neuabtastsignal zu erzeugen; und
das Tiefpassfilter konfiguriert ist, um das Neuabtastsignal zu integrieren.

2. Stromsensorvorrichtung gemäß Anspruch 1, wobei:
der Tastverhältnisberechnungsabschnitt einen Zähler (421) und einen Tastverhältnisumwandlungsabschnitt (423) aufweist;
der Takteinführungsabschnitt einen Basistakterzeugungsabschnitt (441) und einen Frequenzteiler (443) aufweist;
der Basistakterzeugungsabschnitt konfiguriert ist, um ein Basistaktsignal zu erzeugen;
der Zähler konfiguriert ist, um eine Ein-Periode und eine Aus-Periode in jeder Periode des Pulssignals basierend auf dem Basistaktsignal zu zählen;
der Tastverhältnisumwandlungsabschnitt konfiguriert ist, um ein Tastverhältnis aus gezählten Ergebnissen des Zählers für jede Periode des Pulssignals zu berechnen und um ein Tastverhältnissignal zu erzeugen, das das Tastverhältnis darstellt; und
der Frequenzteiler konfiguriert ist, um eine Frequenzteilung für das Basistaktsignal von dem Basistakterzeugungsabschnitt durchzuführen und um ein geteiltes Signal als das Taktsignal auszugeben.

3. Stromsensorvorrichtung gemäß Anspruch 1 oder 2, wobei die Stromsensorvorrichtung ferner einen Komparator (54) aufweist, der konfiguriert ist, um eine Ausgabe des Tiefpassfilters zu empfangen und um die Ausgabe des Tiefpassfilters und einen vorbestimmten Schwellenwert zu vergleichen.

4. Stromsensorvorrichtung gemäß einem der Ansprüche 1 bis 3, wobei:
die selbstschwingende Schaltung eine Antriebsschaltung (24), einen Detektionswiderstand (26) und eine Pulssignalerzeugungsschaltung (28) umfasst;
die Antriebsschaltung einen Antriebsabschnitt (241) und eine Last (243) aufweist;
die Last einen Sekundärleiter umfasst, der auf den Magnetkern gewickelt ist;
der Detektionswiderstand mit der Antriebsschaltung in Reihe geschaltet ist und konfiguriert ist, einen Strom, der durch den Sekundärleiter fließt, in eine Spannung umzuwandeln, um eine erfasste Spannung an einem ihrer Enden zu erzeugen;
die Pulssignalerzeugungsschaltung konfiguriert ist, um das Pulssignal als Reaktion auf die erfasste Spannung zu erzeugen;
der Antriebsabschnitt konfiguriert ist, um eine Fließrichtung des Stroms, der durch den Sekundärleiter fließt, basierend auf dem Pulssignal zu ändern; und
die Pulssignalerzeugungsschaltung konfiguriert ist, um die erfasste Spannung zu überwachen, die an dem einen der Enden des Detektionswiderstands erzeugt wird, und um einen Ein/Aus-Zustand des Pulssignals zu schalten.

5. Stromsensorvorrichtung gemäß Anspruch 4, wobei der Antriebsabschnitt eine H-Brückenschaltung mit vier Schaltern (SW1, SW2, SW3, SW4) umfasst.

6. Stromsensorvorrichtung gemäß einem der Ansprüche 1 bis 3, wobei:
die selbstschwingende Schaltung einen Antriebsschaltungssteuerabschnitt (32) aufweist;
der Antriebsschaltungssteuerabschnitt konfiguriert ist, um eine Frequenzmodulation des Pulssignals während einer vorbestimmten Periode ab dem Einschalten einer Leistung durchzuführen, um ein Entmagnetisierungspulssignal zu erzeugen, das verwendet wird, um eine Wechselstromentmagnetisierung für den Magnetkern durchzuführen, und ein Tastverhältnis von 51,5 ± 1 % aufweist; und
die selbstschwingende Schaltung konfiguriert ist, um basierend auf dem Entmagnetisierungspulssignal für die vorbestimmte Periode zu arbeiten.

7. Stromsensorvorrichtung gemäß Anspruch 6, wobei:
die selbstschwingende Schaltung eine Antriebsschaltung und einen Detektionswiderstand umfasst;
der Detektionswiderstand mit der Antriebsschaltung in Reihe geschaltet ist;
der Detektionswiderstand konfiguriert ist, um zwischen einem ersten Widerstandswert und einem zweiten Widerstandswert, der größer als der erste Widerstandswert ist, als Reaktion auf ein Schaltsignal geschaltet zu werden; und
der Antriebsschaltungssteuerabschnitt konfiguriert ist, um das Schaltsignal zum Auswählen des ersten Widerstandswerts während der vorbestimmten Periode und zum Auswählen des zweiten Widerstandswerts nach der vorbestimmten Periode zu erzeugen, um einen Strom zu steuern, der durch die Antriebsschaltung fließt.

8. Stromsensorvorrichtung gemäß Anspruch 6, wobei:
die selbstschwingende Schaltung eine Antriebsschaltung umfasst;
die Antriebsschaltung einen Antriebsabschnitt und eine Last umfasst;
die Last einen Sekundärleiter umfasst, der auf den Magnetkern gewickelt ist; und
der Antriebsabschnitt der Antriebsschaltung konfiguriert ist, um eine Fließrichtung eines Stroms, der durch den Sekundärleiter fließt, basierend auf dem Entmagnetisierungspulssignal anstelle des Pulssignals während der vorbestimmten Periode zu schalten.

## Revendications

1. Dispositif de capteur de courant (10) qui est d'un type auto-oscillant et détecte un courant circulant à travers un conducteur primaire (70), où :
le dispositif de capteur de courant comprend un circuit auto-oscillant (20), une partie de calcul de rapport cyclique (42), une partie d'introduction d'horloge (44), une partie de rééchantillonnage (46) et un filtre passe-bas (48) ;
le circuit auto-oscillant a un noyau magnétique (22) avec une forme annulaire ;
le conducteur primaire s'étend à travers un trou central du noyau magnétique ;
le circuit auto-oscillant est configuré pour générer un signal d'impulsion en réponse au courant circulant à travers le conducteur primaire et pour fonctionner sur la base du signal d'impulsion ;
la partie de calcul de rapport cyclique est configurée pour calculer un rapport cyclique du signal d'impulsion et pour délivrer en sortie un signal de rapport cyclique représentant le rapport cyclique ;
la partie d'introduction d'horloge est configurée pour générer un signal d'horloge ayant une fréquence constante ;
**caractérisé en ce que**
la partie de rééchantillonnage est configurée pour recevoir le signal de rapport cyclique et le signal d'horloge et pour rééchantillonner le signal de rapport cyclique sur la base du signal d'horloge pour générer un signal de rééchantillonnage ; et
le filtre passe-bas est configuré pour intégrer le signal de rééchantillonnage.

2. Dispositif de capteur de courant selon la revendication 1, où :
la partie de calcul de rapport cyclique comporte un compteur (421) et une partie de conversion de rapport cyclique (423) ;
la partie d'introduction d'horloge comporte une partie de génération d'horloge de base (441) et un diviseur de fréquence (443) ;
la partie de génération d'horloge de base est configurée pour générer un signal d'horloge de base ;
le compteur est configuré pour compter une période de marche et une période d'arrêt dans chaque période du signal d'impulsion sur la base du signal d'horloge de base ;
la partie de conversion de rapport cyclique est configurée pour calculer un rapport cyclique à partir de résultats comptés du compteur pour chaque période du signal d'impulsion et pour générer un signal de rapport cyclique représentant le rapport cyclique ; et
le diviseur de fréquence est configuré pour effectuer une division de fréquence pour le signal d'horloge de base provenant de la partie de génération d'horloge de base et pour délivrer en sortie un signal divisé en tant que signal d'horloge.

3. Dispositif de capteur de courant selon la revendication 1 ou 2, où le dispositif de capteur de courant a en outre un comparateur (54) qui est configuré pour recevoir une sortie du filtre passe-bas et pour comparer la sortie du filtre passe-bas et une valeur de seuil prédéterminée.

4. Dispositif de capteur de courant selon l'une quelconque des revendications 1 à 3, où :
le circuit auto-oscillant comprend un circuit d'attaque (24), une résistance de détection (26) et un circuit de génération de signal d'impulsion (28) ;
le circuit d'attaque a une partie d'attaque (241) et une charge (243) ;
la charge comprend un conducteur secondaire enroulé sur le noyau magnétique ;
la résistance de détection est connectée au circuit d'attaque en série et est configurée pour convertir un courant circulant à travers le conducteur secondaire en une tension pour générer une tension détectée à l'une de ses extrémités ;
le circuit de génération de signal d'impulsion est configuré pour générer le signal d'impulsion en réponse à la tension détectée ;
la partie d'attaque est configurée pour changer une direction de circulation du courant circulant à travers le conducteur secondaire sur la base du signal d'impulsion ; et
le circuit de génération de signal d'impulsion est configuré pour surveiller la tension détectée générée à l'une des extrémités de la résistance de détection et pour commuter un état de marche/arrêt du signal d'impulsion.

5. Dispositif de capteur de courant selon la revendication 4, où la partie d'attaque comprend un circuit en pont en H ayant quatre commutateurs (SW1, SW2, SW3, SW4).

6. Dispositif de capteur de courant selon l'une quelconque des revendications 1 à 3, où :
le circuit auto-oscillant a une partie de commande de circuit d'attaque (32) ;
la partie de commande de circuit d'attaque est configurée pour effectuer une modulation de fréquence du signal d'impulsion pendant une période prédéterminée à partir de la mise en marche d'une puissance pour générer un signal d'impulsion de démagnétisation qui est utilisé pour effectuer une démagnétisation en courant alternatif pour le noyau magnétique et a un rapport cyclique de 51,5 ± 1 % ; et
le circuit auto-oscillant est configuré pour fonctionner sur la base du signal d'impulsion de démagnétisation pendant la période prédéterminée.

7. Dispositif de capteur de courant selon la revendication 6, où :
le circuit auto-oscillant comprend un circuit d'attaque et une résistance de détection ;
la résistance de détection est connectée au circuit d'attaque en série ;
la résistance de détection est configurée pour être commutée entre une première valeur de résistance et une deuxième valeur de résistance supérieure à la première valeur de résistance en réponse à un signal de commutation ; et
la partie de commande de circuit d'attaque est configurée pour générer le signal de commutation pour sélectionner la première valeur de résistance pendant la période prédéterminée et pour sélectionner la deuxième valeur de résistance après la période prédéterminée pour commander un courant circulant à travers le circuit d'attaque.

8. Dispositif de capteur de courant selon la revendication 6, où :
le circuit auto-oscillant comprend un circuit d'attaque ;
le circuit d'attaque comprend une partie d'attaque et une charge ;
la charge comprend un conducteur secondaire enroulé sur le noyau magnétique ; et
la partie d'attaque du circuit d'attaque est configurée pour commuter une direction de circulation d'un courant circulant à travers le conducteur secondaire sur la base du signal d'impulsion de démagnétisation à la place du signal d'impulsion pendant la période prédéterminée.
